Europäisches Patentamt

European Patent Office

Office européen des brevets

(19)

(11) Numéro de publication: **0 089 441**

**B1**

(12) **FASCICULE DE BREVET EUROPEEN**

(45) Date de publication du fascicule du brevet: **21.06.89**

(51) Int. Cl.⁴: **H 03 K 5/15, G 11 C 8/00**

(21) Numéro de dépôt: **82430009.9**

(22) Date de dépôt: **24.03.82**

(54) **Générateur de valeur vraie/complément.**

(43) Date de publication de la demande:
**28.09.83 Bulletin 83/39**

(45) Mention de la délivrance du brevet:
**21.06.89 Bulletin 89/25**

(84) Etats contractants désignés:
**DE FR GB**

(56) Documents cités:
**US-A-3 902 082**
**US-A-3 927 334**
**US-A-4 130 768**
**US-A-4 140 927**
**US-A-4 201 927**

**IBM TECHNICAL DISCLOSURE BULLETIN, vol.
22, no. 3, aou7t 1979, pages 1093-1094, New
York (USA). B. CASSIDY et al.: "Dynamic
mosfet logic clock driver"**

(73) Titulaire: **International Business Machines
Corporation
Old Orchard Road
Armonk, N.Y. 10504 (US)**
(84) **DE GB**

(73) Titulaire: **Compagnie IBM FRANCE
5 Place Vendôme
F-75000 Paris 1er (FR)**
(84) **FR**

(72) Inventeur: **Grandguillot, Michel
16, rue des Chênes
F-91540 Mennecy (FR)**
Inventeur: **Mollier, Pierre
15, rue de Ponthierry
F-77310 Boissise le Roi (FR)**
Inventeur: **Nuez, Jean-Paul
34, rue des Coquelicots
F-91540 Mennecy (FR)**

(74) Mandataire: **Lattard, Nicole
Compagnie IBM France Département de
Propriété Intellectuelle
F-06610 La Gaude (FR)**

Courier Press, Leamington Spa, England.

EP 0 089 441 B1

## Description

Domaine technique

La présente invention concerne un générateur de valeur vraie/complément avec réaction, pouvant particulièrement être utilisé dans un décodeur d'adresses pour une mémoire par exemple.

Il existe de nombreux circuits générateurs de valeurs vraie/complément utilisés avec une matrice de sélection à diodes ou autre pour sélectionner les lignes de mots ou de bits d'une matrice de mémoire. Ces générateurs se sont avérés satisfaisants dans de nombreuses applications.

Par exemple, un tel circuit est décrit dans la publication EP—A—0024496 de la demande de brevet européen déposée le 24 juin 1980 et publiée le 11 mars 1981.

D'autres circuits sont décrits dans les articles parus dans l'''IBM Technical Disclosure Bulletin'' Vol. 14, No. 11, avril 1972, pages 3244 et 3266 et dans le Vol. 24, No. 4, septembre 1981, page 2209.

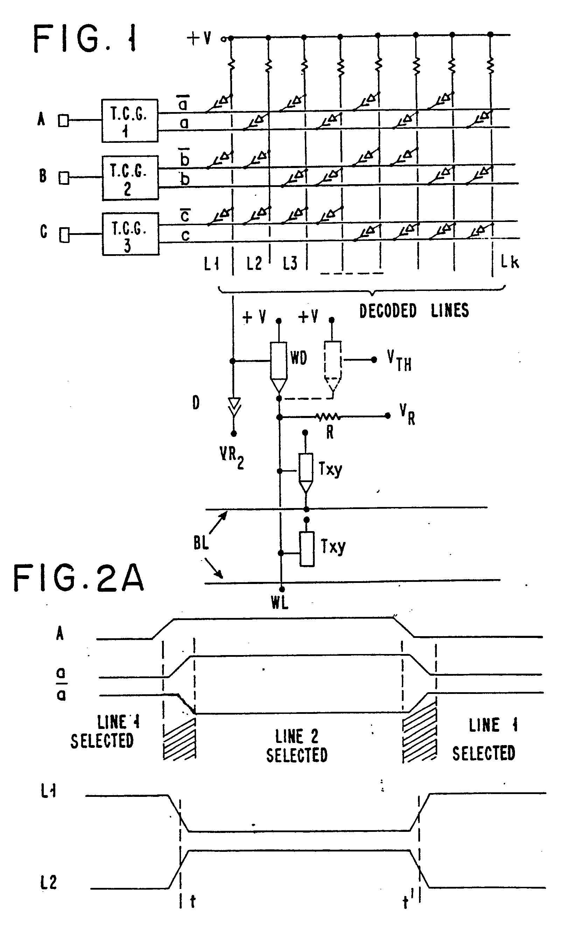

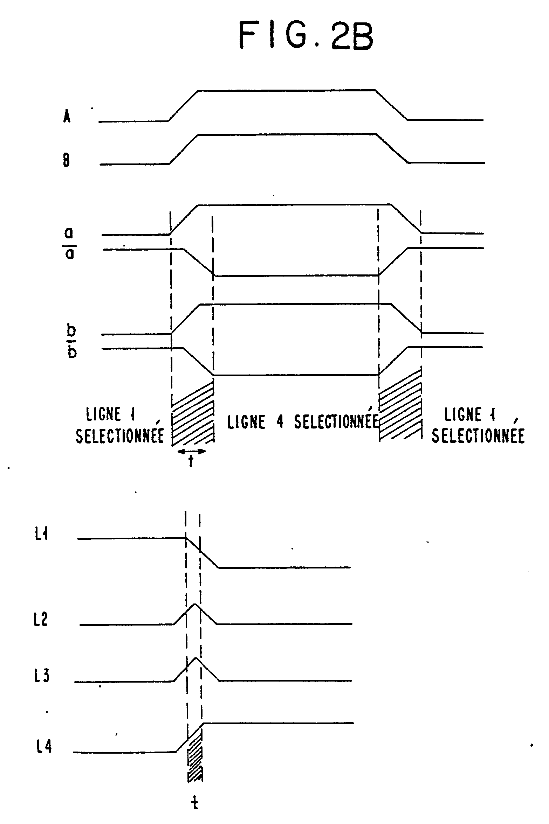

Un inconvénient de ces circuits qui se fait ressentir maintenant que les cycles de lecture et d'écriture sont de plus en plus courts bient du fait que les commutations sur les sorties vraie et complément se produisent simultanément. En effet, pour réaliser la sélection d'une ligne de mots parmi $2^n$ lignes dans un matrice de mémoire, on utilise un décodeur à diodes auquel sont appliqués des signaux d'adresses au moyen de n générateurs de valeur vraie/complément. Dans un tel arrangement des sélections parasites apparaissent chaque fois que les deux sorties d'un ou plusieurs générateurs se trouvent simultanément dans un état qui ne garanti pas la désélection. Ce phénomène sera expliqué plus en détail en référence aux figures 1 et 2.

En conséquence, un objet de la présente invention est de réaliser un circuit générateur de valeur vraie/complément pouvant être utilisé avec un décodeur à diodes.

La présente invention concerne un générateur de valeur vraie/complément d'un signal d'entrée constituant un bit pondéré d'adresse d'une configuration d'adresse utilisée pour la sélection d'une ligne par un décodeur d'adresses à matrice d'éléments semi-conducteurs dans laquelle les lignes horizontales (ou verticales) de la matrice sont constituées par les lignes de sorties valeur vraie et complément des générateurs recevant en entrée les bits pondérés d'adresse et les lignes verticales (ou horizontales) sont constituées par les lignes à sélectionner, les éléments semi-conducteurs étant disposés aux points d'intersection des lignes verticales et de l'une ou l'autre des lignes horizontales recevant la valeur vraie ou le complément du signal d'entrée. Chaque ligne est sélectionnée lorsque des impulsions de sélection mises à un premier niveau logique (haut) sont appliquées sur les lignes horizontales de la matrice connectées aux éléments semi-conducteurs attachés à la ligne à sélectionner. Le générateur comprend un premier circuit recevant le signal d'entrée et fournissant en sortie la valeur vraie (Ø), et un second circuit recevant le signal d'entrée et fournissant en sortie le complément du signal d'entrée.

Conformément à la présente invention, le premier circuit comprend:

un transistor d'entrée inverseur, (T1-1; T1-4) recevant sur sa base le signal d'entrée et fournissant sur son collecteur l'inverse dudit signal;

un circuit de sortie inverseur comportant un transistor de commande (T2-1; T2-4), ayant sa base connectée au collecteur du transistor du circuit d'entrée inverseur et un circuit de sortie de puissance (T3-1 et T5-1; T5-4) comportant au moins un transistor (T5) dont la base est connectée à l'émetteur du transistor de commande pour fournir sur sa sortie (Ø) prise au collecteur dudit transistor le signal de sortie de valeur vraie; et

un transistor (T11-1; T11-4) monté en parallèle sur le transistor de commande (T2-1; T2-4) dont l'état conducteur ou bloqué est commandé par la tension sur sa base, qui connectée au point commun d'un point comportant deux résistances disposées en série entre la sortie du second circuit et une tension de référence de telle sorte que ce transistor lorsqu'il est conducteur retarde l'apparition sur la sortie dudit premier circuit de la transition du signal de sortie au niveau de sélection.

Le second circuit comprend:

un circuit de sortie inverseur comportant un transistor de commande (T2-2; T2-5) ayant sa base connectée à l'entrée du générateur et un circuit de sortie de puissance comportant au moins un transistor (T5) dont la base est connectée à l'émetteur du transistor de commande pour fournir sur sa sortie prise au collecteur dudit transistor le complément du signal d'entrée; et

un transistor (T11-2; T11-5) monté en parallèle sur ledit transistor de commande (T2-2; T2-5), dont l'état conducteur ou bloqué est commandé par la tension sur sa base, qui est connectée au point commun d'un pont diviseur comportant deux résistances disposées en série entre la sortie du premier circuit et la tension de référence de telle sorte que ce transistor lorsqu'il est conducteur retarde l'apparition sur la sortie du second circuit de la transition du signal de sortie au niveau de sélection.

Brève description des figures

La figure 1 représente un circuit de décodage dans lequel peut être incorporée la présente invention.

Les figures 2A et 2B représentent les formes des signaux qui dans les arrangements de décodage de l'art antérieur, provoquent des sélections multiples.

La figure 3 représente un premier mode de réalisation d'un circuit générateur de valeur vraie/complément.

La figure 4 représente un second mode de réalisation d'un circuit générateur de valeur vraie/complément.

Description détaillée de l'invention

Avant de faire la description du circuit de l'invention, on va expliquer en référence à la figure 1, le problème qui se pose, lors de la sélection d'une ligne par un décodeur à diodes.

Les décodeurs à diodes sont des dispositifs couramment utilisés notamment pour sélectionner une ligne dans une matrice de mémoire par exemple. Un tel dispositif est représenté sur la figure 1.

Pour sélectionner $k=2^n$ lignes L1,. . ., Lk avec un décodeur à diodes, il faut n circuits générateurs de valeurs vraie/complément TCG 1 à TCG n.

Dans le schéma représenté à titre d'exemple on a trois générateurs pour sélectionner huit lignes.

Les signaux d'adresses A, B, C sont appliqués aux entrées des générateurs TCG qui fournissent sur leur sortie des signaux a et $\bar{a}$, b et $\bar{b}$, c et $\bar{c}$ respectivement.

Le décodeur est constitué par une matrice dont les lignes horizontales par exemple sont les sorties des circuits TCG et les lignes verticales les lignes à sélectionner, les diodes étant placées de façon adéquate aux intersections d'une ligne horizontale et d'une ligne verticale, pour que lorsqu'une configuration de bits d'adresse pondérés est appliquée en A, B et C, on sélectionne une ligne en bloquant les diodes attachées à cette ligne. Par exemple, lorsque la configuration 000 est appliquée en A, B et C, $\bar{a}$, $\bar{b}$, et $\bar{c}$ sont à 1 et la ligne L1 est sélectionnée.

Dans une telle matrice, des sélections parasites apparaissent chaque fois que les deux sorties d'un ou plusieurs circuits TCG peuvent se trouver dans un état qui ne garantit pas la désélection de la ligne précédemment sélectionnée, lors de la sélection d'une nouvelle ligne. Ce problème apparaît pendant les transitoires de changement d'adresses lorsque le générateur de valeurs vraie/complément TCG présente un retard plus grand sur le flanc de désélection que sur le flanc de sélection. Le problème est particulièrement accentué dans les décodeurs à diodes, pour lesquels la matrice de décodage fournit au circuit un courant de charge qui favorise la sélection.

En référence à la figure 2, ce phénomène va être expliqué.

On va supposer que la ligne L1 était sélectionnée: A, B, C=000 et que l'on veuille sélectionner la ligne L2: A, B, C=100.

Sur la figure 2A, est représenté le nouvel état de la ligne A, a et $\bar{a}$ et les niveaux sur les lignes L1 et L2.

Aux temps t et t' pendant la commutation deux lignes seront sélectionnées: la ligne L1 et la ligne L2 du fait que a et $\bar{a}$ sont à un niveau haut.

Lorsque deux bits d'adresse changent pas exemple quand on veut sélectionner la ligne L4, et que la ligne 1 était précédemment sélectionnée, c'est-à-dire que:

ABC passe de 000 à 110

pendant l'intervalle t de la période transitoire hachurée sur la figure 2B, il y a sélection simultanée des lignes L1 et L4 mais en outre il y a sélection parasite des lignes 2 et 3.

Les états sur les lignes L1, L2, L3 et L4 pendant cette période transitoire sont représentés sur la figure 2B.

Dans le cas d'une mémoire de haute densité à $2^n$ lignes, ce phénomène peut devenir très gênant, car dans le cas le plus défavorable, où tous les bits d'adresse changent, les $2^n$ lignes seront affectés, incluant la ligne que l'on sélectionne et celle que l'on désélectionne.

Les conséquences de ce phénomène vont être données dans le cas où la sélection s'applique à la sélection des lignes de mots d'une mémoire morte du type de celle décrite dans la publication EP—A—0030280 de la demande de brevet européen déposée le 14 novembre 1980 et publiée le 17 juin 1981. Cette mémoire comprend une matrice de transistors Txy, disposés aux intersections de lignes de mots WL et de lignes de bits BL. Sur la figure 1, on a représenté une partie d'un tel ensemble connecté à la ligne L1.

Deux transistors Txy, l'un ayant une émetteur pour représenter un 1 et l'autre n'en ayant pas pour représente un 0 sont les éléments d'emmagasinage. Les lignes L1 à Lk sont connectées aux bases de transistors de commande WD pour la sélection d'une ligne de mot WL. Les transistors WD ont leurs émetteurs connectés, par une résistance R, aux lignes WL et à une tension de référence VR, (de faible valeur (1 volt)), commune à toutes les lignes de mots puisque normalement un seul des transistors WD de l'ensemble est conducteur.

Dans un tel ensemble, pendant les périodes transitoires toutes les lignes peuvent se trouver sélectionnées et tous les transistors WD peuvent être conducteurs, ce qui fait que la tension de référence VR ne supporte plus le courant qui est $2^n$ fois supérieur au courant normal. Donc, la désélection de toutes ces lignes de mots est très difficile et le temps d'accès pour sélectionner la ligne de mots désirée devient très long.

De plus la diode D qui connecte la base du transistor WD à une tension de référence, de deux volts dans un mode de réalisation préféré, ne supporte pas le courant fourni par les $2^n$ résistances r du décodeur.

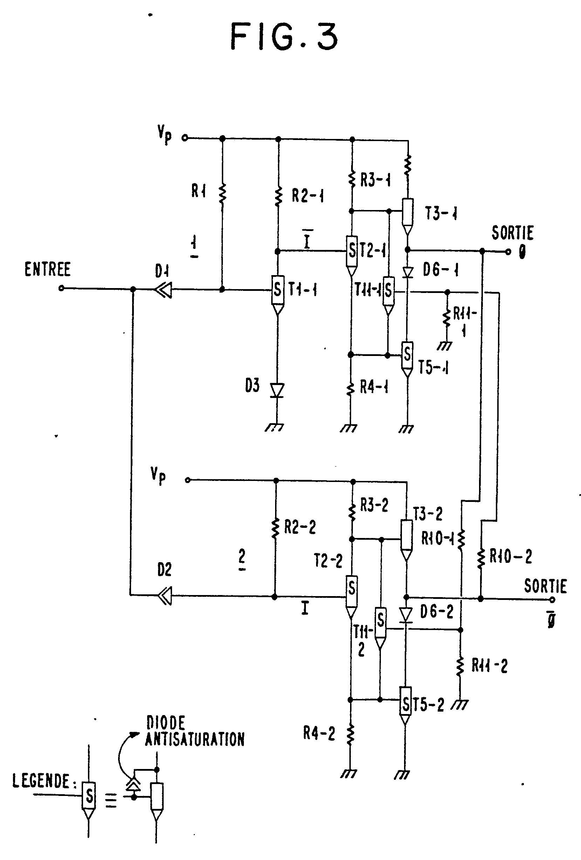

Une solution consisterait à mettre un seuil ($V_{TH}$) de tension entre la sortie du décodeur (ligne L) et les lignes de sélection de la mémoire (ligne de mots WL) comme représenté en pointillés sur la figure 3. Tant que l'impulsion parasite est inférieure à $V_{TH}$, il n'y a pas d'action sur la mémoire. Cette solution présente plusieurs inconvénients.

Il faut intégrer un transistor supplémentaire dans le pas de répétition des cellules, pas qui est très petit dans le cas d'une mémoire morte, la cellule ne comportant qu'un élément semiconducteur. Ajouter ce transistor se ferait au détriment de la surface.

De plus ce transistor conduit du courant en permanence, ce qui augmente la puissance.

Il y a une tension de référence de plus à distribuer dans la mémoire.

La sélection est retardée au passage du seuil.

Conformément à la présente invention telle que revendiquée, le circuit utilisé comme générateur de valeur vraie/complément élimine les impulsions parasites sur les lignes de sortie du décodeur. Les impulsions de sorties Ø et Ø̄ de chacun des générateurs sont telles, que la montée d'une phase ne s'opère que si la sortie, en opposition de phase, est déjà descendue jusqu'à un certain seuil qui est le seuil de désélection totale d'une ligne.

Le signal d'entrée est appliqué aux deux circuits 1 et 2 du générateur par deux diodes D1 et D2.

Le premier circuit 1, comporte un inverseur constitué par le transistor T1-1, dont la base et le collecteur sont connectés à la tension de polarisation $V_p$ par deux résistances R1 et R2-1. L'émetteur de T1-1 est connecté à la masse par la diode D3. Sur le collecteur du transistor T1-1, est engendré un signal $\bar{I}$ qui est l'inverse du signal d'entrée. Un signal I en phase avec le signal d'entrée est utilisé dans le circuit 2, à l'anode de la diode D2.

Les deux signaux I et $\bar{I}$ commandent chacun un circuit de puissance de type push-pull.

Ces deux circuits étant identiques, on a utilisé les mêmes références pour désigner des éléments remplissant les mêmes fonctions, les éléments du circuit 1 ayant un suffixe 1 et ceux du circuit 2 un suffixe 2. On ne fera donc que la description d'un seul circuit par exemple le circuit 1.

Un transistor déphaseur T2-1 reçoit sur sa base le signal $\bar{I}$. Il a son émetteur connecté à la masse par une résistance R4-1 et son collecteur connecté à la tension de polarisation $V_p$ par une résistance R3-1.

Un transistor (pull) T3-1 a sa base connectée au collecteur du transistor T2-1, son collecteur connecté à la tension de polarisation et son émetteur connecté au collecteur d'un transistor (push) T5-1 par une diode D6-1. La base de T5-1 est connectée à l'émetteur de T2-1 et son émetteur est connecté à la masse.

La sortie en phase Ø est prise à l'émetteur du transistor T3-1 et la sortie complément Ø̄ est prise à l'émetteur de T3-2.

Un transistor T11-1 est monté en parallèle sur T2-1, son collecteur est connecté au collecteur de T2-1 et son émetteur est connecté à l'émetteur de T2-1.

La base de T11-1 est connectée au point milieu d'un pont diviseur comprenant la résistance R11-1 connectée à la masse et la résistance R10-2 connectée à la sortie Ø̄ du circuit 2.

Le fonctionnement du circuit est le suivant:

1. Soit un niveau haut en entrée.

T1-1 étant conducteur, la tension collecteur de T1-1 est au niveau bas; celui-ci est légèrement supérieur à 1 $V_{BE}$, soit 1,0 volt dans un mode de réalisation préféré. ($V_{BE}$ est la tension base-émetteur d'un transistor).

Le transistor T2-1 est légèrement conducteur de façon à transmettre une tension base au transistor T5-1 inférieure à 1$V_{BE}$, ce qui fait que ce transistor est bloqué.

La tension collecteur du transistor T2-1 est haute (voisine de la tension de polarisation $V_p$), ce qui rend T3-1 conducteur et amène un niveau haut sur la sortie Ø. La tension obtenue par division de ce niveau par R10-1 et R11-2 est appliquée à la base du transistor T11-2 du circuit 2. Ce qui rend ce transistor conducteur.

En conséquence, le transistor T5-2 conduit et le transistor T3-2 est bloqué, le niveau Ø̄ est bas. Cette tension de sortie basse est divisée par R10-2 et R11-1 et appliquée à la base du transistor T11-1, ce qui le bloque.

2. Une transition descendante est appliquée sur l'entrée.

Cette transition tend à bloquer le transistor T1-1 et le transistor T2-2. Le blocage du transistor T2-2 ne modifie pas l'état des transistors T3-2 et T5-2, tant que T11-2 est maintenu conducteur par l'état haut de la sortie Ø.

T1-1 se bloque, rendant le transistor T2-1 conducteur, ce qui rend le transistor T5-1 conducteur et bloque le transistor T3-1, on obtient un signal descendant sur la sortie Ø.

Lorsque la sortie Ø atteint un niveau suffisamment bas, le transistor T11-2 se bloque, déverrouillant la base de T3-2 sur laquelle la tension monte et libérant la base du transistor T5-2 qui est remenée à la masse par la résistance R4-2. Le transistor T5-2 se bloque donc et la sortie Ø̄ se met à monter.

La montée de cette sortie Ø̄ ne se produit que lorsque Ø a atteint un seuil déterminé par R10-1, R11-2.

3. Une transition montante à partir de l'état final obtenu précédemment est appliquée à l'entrée.

Le processus contraire à celui décrit précédemment se produit. Cette transition montante va rendre conducteurs les transistors T1-1 et T2-2.

Aucune modification du signal sur la sortie Ø ne se produira tant que le transistor T11-1 est maintenu conducteur par la sortie Ø̄ (haute) et par le diviseur R11-1, R10-2.

Par contre le signal d'entrée sera transmis par T2-2 à T3-2 et T5-2, ce qui provoque la descente du signal Ø̄.

C'est seulement lorsque Ø̄ aura atteint le seuil déterminé par R10-2 et R11-1 que la sortie Ø sera déverrouillée et qu'elle pourra monter. Le séquencement est aussi obtenu dans cette hypothèse là.

Le seuil qui autorise la montée du signal de sortie est aisément ajustable en agissant sur les rapports de résistances R11/R11+R10 dans les circuits 1 et 2. Ceci permet d'ajuster avec précision le séquencement de Ø et Ø̄ et donc d'améliorer le délai si le circuit contrôlé, par ces signaux le permet.

La plage d'ajustement du seuil défini par ces résistances peut être étendue en connectant ces ponts:

· soit directement au collecteur du transistor T5-1 et T5-2,

· soit sur la base de T3-1 et T3-2.

La puissance dissipée par ce transistor supplémentaire est négligeable comparée à l'économie importante de puissance transitoire dans le décodeur et dans la matrice commandée par ce décodeur.

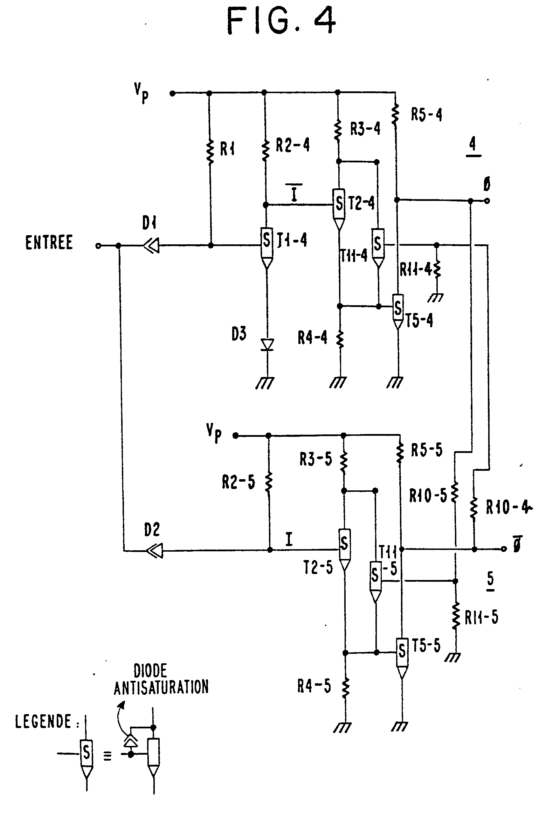

Le principe de ce circuit peut également être appliqué à des circuits non "push-pull" dont un exemple de réalisation est représenté sur la figure 4.

Le circuit de la figure 4 comporte deux circuits 4 et 5, le premier fournissant la sortie vraie Ø et le second la sortie complémentaire Ø̄.

Les circuits 4 et 5 comportent des éléments analogues à ceux des circuits 1 et 2, ils portent dons les mêmes numéros de référence suivis des suffixes 4 et 5. La disposition des transistors de sortie T5-4 et T5-5 change, leurs collecteurs étant connectés à la tension de polarisation par une résistance R5-4 et R5-5 respectivement.

La disposition des transistors T11-4 et T11-5 dont les bases sont attaquées par la tension prise au point commun des résistances R10-4, R11-4 et R10-5, R11-5 permet d'obtenir le même résultat que dans le circuit de la figure 3.

Dans le mode de réalisation préféré de la présente invention, la sélection d'une ligne de mots choisie impose que les bits d'adresse correspondant appliqués à l'entrée bloquent les diodes associées à cette ligne dans la matrice, c'est-à-dire la sélection est effectuée par le front de montée de Ø ou Ø̄ suivant la ligne choisie. C'est pourquoi les transistors de contrôle de retard T11-1 et T12-2 retardent l'apparition du front de montée sur Ø̄ lorsqu'un front descendant est appliqué à l'entrée et l'apparition du front de montée sur Ø lorsqu'un front montant est appliqué à l'entrée.

Il est évident que dans l'hypothèse inverse, il faudrait modifier le montage en utilisant des transistors de conductivité inverse pour que ce soit la sélection qui soit retardée.

Un circuit à transistors à effet de champ qui est connu du document US—A—3 927 334 publié le 16.12.1975 emploie aussi le principe de couplage croisé pour supprimer le chevauchement des phases complémentaires pendant les périodes transitoires. Bien que ce document suggère de ne pas se limiter à commander une borne de sortie par le signal apparaissant sur la borne complémentaire (et vice-versa) ou de commande un étage en amont de celui-ci, il ne suggère pas de court-circuiter la sortie du transistor de commande du circuit de puissance comme dans un circuit à transistors bipolaires tel que revendiqué dans la présente demande.

**Revendications**

1. Générateur de valeur vraie/complément d'un signal d'entrée constituant un bit pondéré d'adresse d'une configuration d'adresse utilisée pour la sélection d'une ligne par un décodeur d'adresses à matrice d'éléments semi-conducteurs dans laquelle les lignes horizontales (ou verticales) de la matrice sont constituées par les lignes de sorties valeur vraie et complément des générateurs recevant en entrée les bits pondérés d'adresse et les lignes verticales (ou horizontales) sont constituées par les lignes à sélectionner, les éléments semi-conducteurs étant disposés aux points d'intersection des lignes verticales et de l'une ou l'autre des lignes horizontales recevant la valeur vraie ou la complément du signal d'entrée, chaque ligne étant sélectionnée lorsque des impulsions de sélection mises à un premier niveau logique (haut) sont appliquées sur les lignes horizontales de la matrice connectées aux éléments semi-conducteurs attachés à la ligne à sélectionner, comprenant un premier circuit recevant le signal d'entrée et fournissant en sortie la valeur vraie (Ø), et un second circuit recevant le signal d'entrée et fournissant en sortie le complément du signal d'entrée et caractérisé en ce que les premier et second circuits comprennent:

dans le premier circuit:

un transistor d'entrée inverseur, (T1-1; T1-4) recevant sur sa base le signal d'entrée et fournissant sur son collecteur l'inverse dudit signal;

un circuit de sortie inverseur comportant un transistor de commande (T2-1; T2-4), ayant sa base connectée au collecteur du transistor du circuit d'entrée inverseur et un circuit de sortie de puissance (T3-1 et T5-1; T5-4) comportant au moins un transistor (T5) dont la base est connectée à l'émetteur du transistor de commande pour fournir sur sa sortie (Ø) prise au collecteur dudit transistor le signal de sortie de valeur vraie; et

un transistor (T11-1; T11-4) monté en parallèle sur le transistor de commande (T2-1; T2-4), dont l'état conducteur ou bloqué est commandé par la tension sur sa base, qui est connectée au point commun d'un pont comportant deux résistances disposées en série entre la sortie du second circuit et une tension de référence de telle sorte que ce transistor retarde lorsqu'il est conducteur l'apparition sur la sortie dudit premier circuit, de la transition du signal de sortie au niveau de sélection;

dans le second circuit:

un circuit de sortie inverseur comportant un transistor de commande (T2-2; T2-5) ayant sa base connectée à l'entrée du générateur et un circuit de sortie de puissance comportant au moins un transistor (T5) dont la base est connectée à l'émetteur du transistor de commande pour fournir sur sa sortie prise au collecteur dudit transistor le complément du signal d'entrée; et

un transistor (T11-2; T11-5) monté en parallèle sur ledit transistor de commande (T2-2; T2-5), dont l'état conducteur ou bloqué est commandé par la tension sur sa base, qui est connectée au point commun d'un pont diviseur comportant deux résistances disposées en série entre la sortie du premier circuit et la tension de référence de telle sorte que ce transistor retarde lorsqu'il est conducteur l'apparition sur la sortie du second circuit de la transition du signal de sortie au niveau de sélection.

2. Générateur selon la revendication 1 caractérisé en ce que les circuits de sortie de puissance des premier et second circuits comprennent:

un premier transistor (T3-1; T3-2) dont la base est connectée au collecteur du transistor de commande (T2-1; T2-2),

un second transistor (T5-1; T5-2) dont la base est connectée à l'émetteur du transistor de commande (T2-1; T2-2), et dont le collecteur est connecté à l'émetteur du premier transistor et constitue la sortie du circuit.

3. Générateur selon la revendication 1 caractérisé en ce que les circuits de sortie de puissance des premier et second circuits comprennent:

un transistor (T5-4; T5-5) ayant sa base connectée à l'émetteur du transistor de commande (T2-4; T2-5), la sortie desdits circuits étant prise sur le collecteur de ce transistor.

**Patentansprüche**

1. Generator des Echtwerts/Komplements eines Eingangssignals, bestehend aus einem gewichteten Adressbit einer Adressenkonfiguration, die für die Auswahl einer Leitung durch einen Adressendekodierer mit Halbleitermatrizenelementen verwendet wird, in der die horizontalen (oder vertikalen) Linien der Matrize aus Ausgangsleitungen mit Echtwert und Komplement der Generatoren bestehen, die am Eingang die gewichteten Adressbits empfangen, und die vertikalen (oder horizontalen) Linien aus auszuwählenden Leitungen bestehen, wobei die Halbleiterelemente an den Schnittpunkten der vertikalen Linien und der einen oder anderen der horizontalen Linien angeordnet sind, die den echten Wert oder das Komplement des Eingangssignals empfangen, wobei jede Leitung ausgewählt wird, wenn die auf einen ersten Logikpegel (hoch) gesetzten Auswahlimpulse an die horizontalen Linien der Matrize angelegt werden, die an die der auszuwählenden Leitung zugeordneten Halbleiterelemente angeschlossen sind, die eine erste Schaltung enthält, die das Eingangssignal aufnimmt und am Ausgang den Echtwert abgibt (Ø), und eine zweite Schaltung, die das Eingangssignal empfängt und am Ausgang das Komplement des Eingangssignals ausgibt, dadurch gekennzeichnet, dass die erste und die zweite Schaltung enthalten:

in der ersten Schaltung:

einen Eingangs-Umkehrtransistor (T1-1; T1-4), der an seiner Basis das Eingangssignal empfängt und an seinem Kollektor den Kehrwert des besagten Signals abgibt;

eine Ausgangs-Umkehrschaltung mit einem Steuertransistor (T2-1; T2-4), dessen Basis an den Kollektor des Eingangs-Umkehrkreises gelegt ist, und einen Ausgangs-Leistungskreis (T3-1 und T5-1; T5-4), der mindestens einen Transistor (T5) enthält, dessen Basis an den Emitter des Steuertransistors gelegt ist, um an seinem Ausgang (Ø) am Kollektor des besagten Transistors das Echtwert-Ausgangssignal abzugeben; und

einen Transistor (T11-1; T11-4) parallel zum Steuertransistor (T2-1; T2-4) montiert, dessen leitender oder gesperrter Zustand durch die Spannung an seiner Basis gesteuert wird, die am gemeinsamen Punkt einer Brücke angeschlossen ist, welche zwei in Reihe geschaltete Widerstände zwischen dem Ausgang der zweiten Schaltung und einer Bezugsspannung enthält, so dass dieser Transistor, wenn er leitet, das Auftreten des Übergangs des Ausgangssignals auf den Auswahlpegel am Ausgang der besagten ersten Schaltung verzögert;

in der zweiten Schaltung:

eine Ausgangs-Umkehrschaltung mit einem Steuertransistor (T2-2; T2-5), dessen Basis an den Eingang des Generators gelegt ist, und einen Ausgangs-Leistungskreis mit mindestens einem Transistor (T5), dessen Basis an den Emitter des Steuertransistors gelegt ist, um an seinem Ausgang, am Kollektor des besagten Transistors, das Komplement des Eingangssignals abzugeben; und

einen Transistor (T11-2; T11-5), parallel zum besagten Steuertransistor (T2-2; T2-5) geschaltet, dessen Zustand, leitend bzw. gesperrt, durch die Spannung an seiner Basis gesteuert wird, die an den gemeinsamen Punkt einer Teilerbrücke gelegt ist, welche zwei in Reihe geschaltete Widerstände zwischen dem Ausgang der ersten Schaltung und der Bezugsspannung enthält, sodass dieser Transistor, wenn er leitet, das Auftreten des Übergangs des Ausgangssignals im Auswahlpegel am Ausgang der zweiten Schaltung verzögert.

2. Generator gemäss Anspruch 1, dadurch gekennzeichnet, dass die Ausgangsleistungskreise der ersten und zweiten Schaltung enthalten:

einen ersten Transistor (T3-1; T3-2) dessen Basis an den Kollektor des Steuertransistors (T2-1; T2-2) gelegt ist,

einen zweiten Transistor (T5-1; T5-2), dessen Basis an den Emitter des Steuertransistors (T2-1; T2-2) gelegt ist, und dessen Kollektor an den Emitter des ersten Transistors gelegt ist und den Ausgang der Schaltung bildet.

3. Generator gemäss Anspruch 1, dadurch gekennzeichnet, dass die Ausgangsleistungskreise der ersten und zweiten Schaltung enthalten:

einen Transistor (T5-4; T5-5), dessen Basis an den Emitter des Steuertransistors (T2-4; T2-5) gelegt ist, während der Ausgang der besagten Schaltungen am Kollektor dieses Transistors abgegriffen wird.

**Claims**

1. A device for generating true/complement values of an input signal constituting a weighted address bit of an address configuration used for line selection purposes by an address decoder comprising a matrix of semiconductor elements in which the horizontal (or vertical) lines are the true/complement output lines of generators that receive as inputs the weighted address bits, and in which the vertical (or horizontal) lines comprise the lines to be selected, the semiconductor elements being located at the intersections of the vertical lines and of either of the horizontal lines that receive the true value of the input signal or the complement value thereof, each line being selected when selection pulses at a first logic level (up level) are applied to the horizontal lines of the matrix that are connected to the semiconductor elements associated with the line to be selected, said device including a first circuit that receives the input signal and produces the true value (∅) thereof at its output, and a second circuit that receives the input signal and produces the complement value thereof at its output, and being characterized in that said first and second circuits include:

in the first circuit:

—an input inverter transistor (T1-1; T1-4) the base of which receives the input signal and the collector of which provides the inverse of said signal;

—an output inverter circuit comprising a control transistor (T2-1; T2-4) the base of which is connected to the collector of the input inverter transistor and a power output circuit (T3-1 and T5-1; T5-4) including at least one transistor (T5) the base of which is connected to the emitter of the control transistor, to produce at its (∅) output taken from the collector of said transistor the true value of the input signal; and

—a transistor (T11-1; T11-4) connected in parallel with the control resistor (T2-1; T2-4) and the on or off condition of which is controlled by the voltage on its base, which is connected to the common node of a bridge comprising two resistors connected in series between the output of the second circuit and a reference voltage, so that this transistor, when turned on, will cause the occurrence of the output signal transition to the selection level at the output of said first circuit to be delayed;

in the second circuit:

—an output inverter circuit comprising a control transistor (T2-2; T2-5) the base of which is connected to the input of the generator and a power output circuit including at least one transistor (T5) the base of which is connected to the emitter of the control transistor, to produce at its output taken from the collector of said transistor the complement of the input signal; and

—a transistor (T11-2; T11-4) connected in parallel with said control transistor (T2-2; T2-5) and the on or off condition of which is controlled by the voltage on its base, which is connected to the common node of a divider bridge comprising two resistors connected in series between the output of the first circuit and the reference voltage, so that this transistor, when turned on, will cause the occurrence of the output signal transition to the selection level at the output of the second circuit to be delayed.

2. A device according to claim 1, characterized in that the power output circuits in said first and second circuits include:

a first transistor (T3-1; T3-2) the base of which is connected to the collector of the control transistor (T2-1; T2-2),

a second transistor (T5-1; T5-2) the base of which is connected to the emitter of the control transistor (T2-1; T2-2) and the collector of which is connected to the emitter of the first transistor and constitutes the output of the circuit.

3. A device according to claim 1, characterized in that the power output circuits of said first and second circuits include:

a transistor (T5-4; T5-5) the base of which is connected to the emitter of the control transistor (T2-4; T2-5), the output of said circuits being taken from the collector of said transistor.

# FIG. 1

# FIG. 2A

# FIG. 2B

LIGNE 1
SELECTIONNÉE   LIGNE 4 SELECTIONNÉE   LIGNE 1
SELECTIONNÉE

L1

L2

L3

L4

t

# FIG. 3

SORTIE 0

SORTIE $\overline{0}$

ENTREE

LEGENDE:

DIODE ANTISATURATION

3

# FIG. 4

LEGENDE :

DIODE
ANTISATURATION